# EUROPEAN PATENT APPLICATION

(11) **EP 1 244 202 A2**
(43) Date of publication of application: **25.09.2002**
(21) Application number: 02006404.4
(22) Date of filing: 21.03.2002
(51) Int. Cl.: H02M 3/158

(54) **Semiconductor device**

(30) Priority: 23.03.2001 JP 2001085622
(71) Applicant: TDK Corporation, Chuo-ku, Tokyo (JP)
(72) Inventor: Hirokawa, Masahiko, c/o TDK Corporation, Tokyo (JP); Matsuura, Ken, c/o TDK Corporation, Tokyo (JP); Takagi, Masakazu, c/o TDK Corporation, Tokyo (JP)
(74) Representative: Grünecker, Kinkeldey, Stockmair & Schwanhäusser Anwaltssozietät

(57) **Abstract**

A semiconductor device that can short-circuit with a low impedance a gate-to-source capacitance of an FET as a main switch device. The aforementioned semiconductor device includes a first FET, a second FET, and a package. The first FET and the second FET are placed in the package. The first FET composes a main switch device. The second FET has its drain and source connected to the gate and the source of the first FET. The package includes external terminals for the first and second FETs on its outer surface.

## Description

### BACKGROUND OF THE INVENTION

The present invention relates to a semiconductor device that uses a plurality of field effect transistors (hereinafter referred to as FETs) and a DC-to-DC converter that uses this semiconductor device in a synchronous rectifier circuit.

A high-speed output rectifying diode has been used as a rectifying device for a DC-to-DC converter. As the output voltage gets lower and the current gets larger, the forward voltage drop of a diode is no longer negligible. As a countermeasure against this problem, a so-called synchronous rectifier circuit system that uses a switch device such as an FET providing a smaller voltage drop in the conductive state has been proposed and put to practical use.

In case an FET is used as a rectifying device of a synchronous rectifier circuit, control is made via a voltage across the gate terminal and the source terminal, a malfunction may occur especially in the non-conductive (off) state where disturbance causes a voltage to be applied across these terminals thus providing the conductive (on) state. JP-A-08-289538 discloses a circuit that short-circuits terminals via another switch device in the off period of a rectifying device in order to prevent malfunction caused by an external noise.

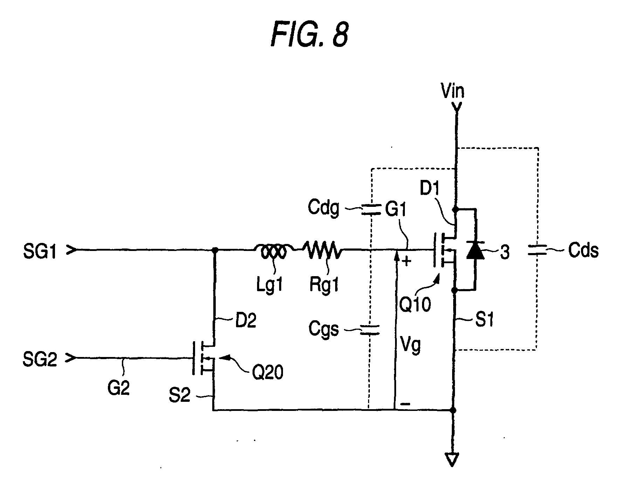

Fig. 8 shows part of a synchronous rectifier circuit of a related art DC-to-DC converter. The synchronous rectifier circuit uses an FET as a rectifying device Q10 and short-circuits a gate G1 and a source S1 by using a switch device Q20 via FET in the off period of the rectifying device Q10.

Between a drain D1 and a source S1 of the rectifying device Q10 is connected a diode 3 such as a Schottky diode at reversed polarities. Drive signals SG1 and SG2 are supplied to a gate G1 of the rectifying device Q10 and a gate G2 of a switch device Q20 respectively with a predetermined timing.

Assuming that the switch device Q20 is not used in the operation of the circuit shown in Fig. 8, in case an input voltage Vin is applied on the rectifying device Q10 in a period when the rectifying device Q10 should be off, a voltage Vds on the drain D1 of the rectifying device Q10 rises abruptly from 0 to the input voltage Vin. With a variation (dVds/dt) in the voltage, a recharging current flows into a gate-to-source capacitance Cgs via a feedback capacitance Cdg across the gate G1 and the drain D1 thus increasing a gate voltage Vg. When the gate voltage reaches a threshold voltage via this recharging action, the rectifying device Q10 that should be off could enter the on state (self turn-on state).

As shown in Fig. 8, in case a switch device Q20 is used to short-circuit the gate G1 and the source S1, the gate voltage Vg can be retained below a threshold voltage (virtually zero) . Thus it seems that the rectifying device Q10 that should be off is prevented from entering the on state (self turn-on state).

However, in reality, in a circuit where a drain D2 and a source S2 of the switch device Q20 are connected to the gate G1 and the source S1 of the rectifying device Q10 in order to short-circuit the gate and the source, a wiring impedance, more specifically, a wiring resistance Rg1, a wiring inductance Lg1, and an impedance within a device (a resistance Rg, an inductance Lg) are present and are connected in parallel with the gate-to-source capacitance Cgs equivalently. Thus it is impossible to decrease the gate-to-source voltage Vgs sufficiently below the threshold.

Thus, it cannot be perfectly prevented the rectifying device Q10 that should be off from entering the on state (self turn-on state).

### SUMMARY OF THE INVENTION

The object of the invention is to provide a semiconductor device that can short-circuit with a low impedance a gate-to-source capacitance of an FET as a main switch device and a DC-to-DC converter that uses the semiconductor device.

Another object of the invention is to provide a semiconductor device and a DC-to-DC converter that can contribute to reduction of size, number of parts and costs.

In order to solve the aforementioned problems, a semiconductor device according to the invention comprises a first field effect transistor (FET), a second FET, and a package. The first FET and the second FET are placed in the package. The first FET composes a main switch. The second FET has its drain and source connected to the gate and the source of the first FET. The package comprises external terminals on its outer surface. The drains, sources or gates of the first and second FETs are connected to the external terminals.

As mentioned earlier, the first FET composes the main switch and the second FET has its drain and source connected to the gate and the source of the first FET as the main switch. Thus it is possible to short-circuit, by using the second FET, the gate and the source of the first FET composing the main switch. In case a voltage is applied on the first FET in a period when the first FET should be off, it is possible to drive the gate of the second FET in synchronization with application of this voltage and short-circuit the gate-to-source capacitance of the first FET with low impedance.

Further, the first and second FETs are in the same package and the wiring impedance of the second FET is remarkably low so that it is possible to decrease the gate-to-source voltage sufficiently below the threshold voltage.

Further, the package comprises terminals for connecting the drains, sources or gates of the first and second FETs on its outer surface. Thus a semiconductor device according to the invention can be directly mounted on a circuit board as a single component, and can contribute to reduction of size, number of parts and costs.

### BRIEF DESCRIPTION OF THE DRAWINGS

Fig. 1 shows an equivalent circuit and a general configuration of a semiconductor device according to the invention;
Fig. 2 is a perspective view showing an exemplary external view of a semiconductor device according to the invention;
Fig. 3 shows the circuit operation of a semiconductor device according to the invention shown in Figs. 1 and 2;
Fig. 4 shows another embodiment of a semiconductor device according to the invention;
Fig. 5 shows still another embodiment of a semiconductor device according to the invention;
Fig. 6 shows still another embodiment of a semiconductor device according to the invention;
Fig. 7 shows a synchronous rectifier system step-down DC-to-DC converter using a semiconductor device shown in Figs. 1 through 4 as a commutation switch device; and
Fig. 8 is a circuit diagram showing part of a synchronous rectifier circuit of a related art DC-to-DC converter.

### DETAILED DESCRIPTION OF THE PREFERRED EMBODIMENTS

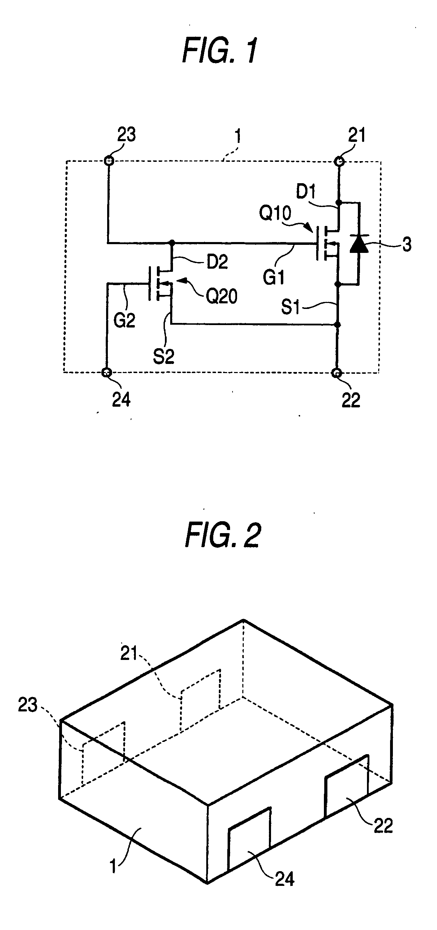

Fig. 1 shows an equivalent circuit and a general configuration of a semiconductor device according to the invention. The semiconductor device illustrated comprises a first FET Q10, a second FET Q20, and a package 1. The first FET Q10 and the second FET Q20 are in the package 1. The first FET Q10 composes a main switch. The second FET Q20 has its drain D2 and source S2 connected to the gate G1 and the source S1 of the first FET Q10. The package 1 comprises terminals for the first and second FETs Q10 and Q20 on its outer surface. In the illustrated embodiment, the first FET Q10 and the second FET Q20 comprise a single chip. That is, the first FET Q10 and the second FET Q20 are mounted on a single silicon substrate.

In the first FET Q10, a gate G1 is connected to an external terminal 23, a drain D1 to an external terminal 21, and a source S1 to a terminal 22. A gate G2 of the second FET Q2 is connected to an external terminal 24. Between a drain D1 and a source S1 of the FET Q10 is connected a diode 3 such as a Schottky diode. The diode 3 can be replaced with a built-in diode of the first FET Q10.

Fig. 2 is a perspective view showing an exemplary external view of a semiconductor device according to the invention. On the outer surface of the package 1 are provided the aforementioned external terminals independently of each other.

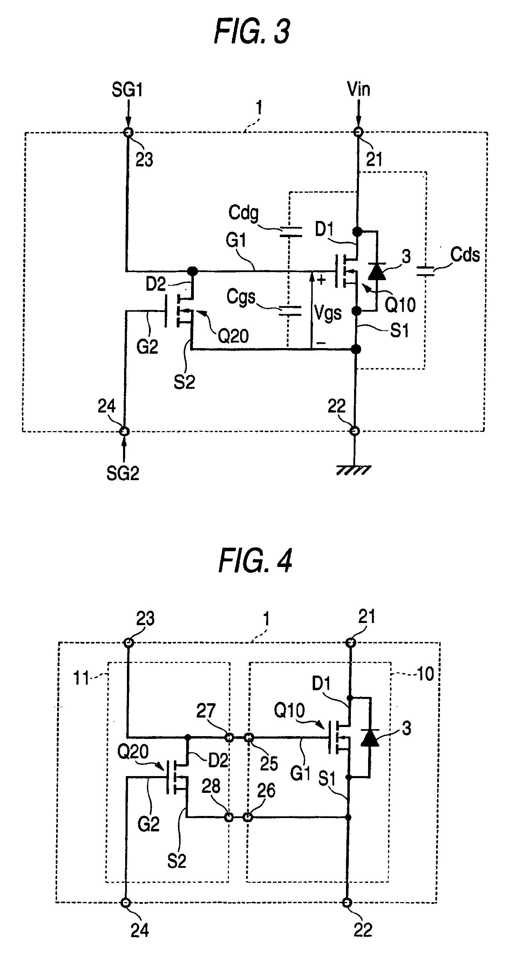

Fig. 3 shows the circuit operation of a semiconductor device according to the invention shown in Figs. 1 and 2. As shown in Fig. 3, the first FET Q10 has a gate-to-source capacitance Cgs, a drain-to-gate capacitance Cdg and a drain-to-source capacitance Cds. Drive signals SG1 and SG2 are supplied to the gate G1 of the first FET Q10 and the gate G2 of a switch device Q20 with a predetermined timing.

In case an input voltage Vin is applied across the drain D1 and the source S1 of the first FET Q10 in a period when the first FET Q10 driven by a drive signal SG1 supplied to an external terminal 23 is turned off, a voltage Vds on the drain D1 of the first FET Q10 rises abruptly from 0 to the input voltage Vin.

Thus, in synchronization with the timing the input voltage Vin is supplied, a drive signal SG2 is supplied to the external terminal 24 to turn on the second FET Q20. This causes the second FET Q20 to short-circuit the gate G1 and the source S1 of the first FET Q10, thereby short-circuiting the gate-to-source capacitance of the first FET Q10 with a low impedance.

Further, the first FET Q10 and the second FET Q20 are in the same package 1 and the wiring impedance across the second FET Q20 and the first FET Q10 is remarkably low so that it is possible to decrease the gate-to-source voltage Vgs sufficiently below the threshold voltage. This reliably avoids the risk of the first FET Q10 that should be off entering the on state (self turn-on state).

Further, the package 1 comprises external terminals 21 through 24 on its outer surface. The drains D1, D2, sources S1, S2 and gates G1, G2 of the first and second FETs are connected to these terminals 21 through 24. Thus the package 1 can be directly mounted on a circuit board as a single component.

Fig. 4 shows another embodiment of a semiconductor device according to the invention. In the figure, the same sections as those in Fig. 1 are given the same reference numerals. In this embodiment, the first FET Q10 and the second FET Q20 are arranged on separate chips 10, 11 and integrated by the package 1. The terminal 25 connected to the gate G1 of the first FET Q10 and the terminal 27 connected to the drain D2 of the second FET Q20 are arranged in close proximity to provide electric conduction. The drain D2 of the second FET Q20 and the terminals 25, 27 are connected to the terminal 23. In this embodiment also, the same effects are obtained as the embodiment in Fig. 1 mentioned earlier.

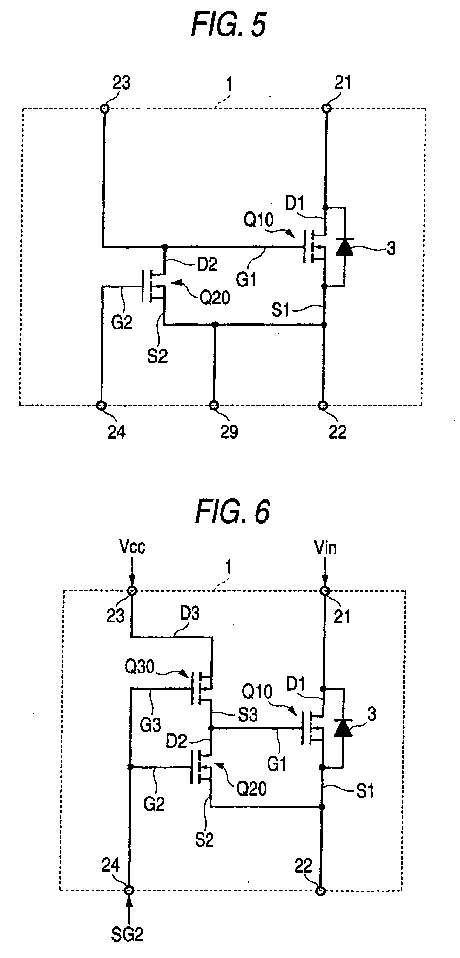

Fig. 5 shows still another embodiment of a semiconductor device according to the invention. In the figure, the same sections as those in Fig. 1 are given the same reference numerals . In this embodiment, the source S2 of the second FET Q20 is isolated from the source S2 of the first FET Q1 and connected to an external terminal 29 provided separately from the external terminal 22. The sources S1 and S2 can be conducted electrically on the component side of a substrate. The first FET Q10 and the second FET Q20 may be arranged on a single chip or formed into separate chips. This embodiment also provides the same effects as the embodiment in Fig. 1 mentioned earlier.

Fig. 6 shows still another embodiment of a semiconductor device according to the invention. In the figure, the same sections as those in Fig. 1 are given the same reference numerals . In this embodiment, the semiconductor device comprises a third FET Q30, by which the gate G1 of the first FET Q10 is driven. In the embodiment, the first FET Q10 and the second FET 20 comprise n-channels and the third FET Q30 comprise a p-channel. A drain D3 of the third FET Q30 is connected to the external terminal 23. An operating voltage Vcc is supplied to the external terminal 23.

A gate G3 of the third FET Q30 is, together with the gate G2 of the second FET Q20, connected to the external terminal 24. Further, a source S3 of the third FET Q30 is connected to the gate G1 of the first FET Q10. The first FET Q10, the second FET Q20 and the third FET Q30 may be arranged on a single chip or formed into separate chips.

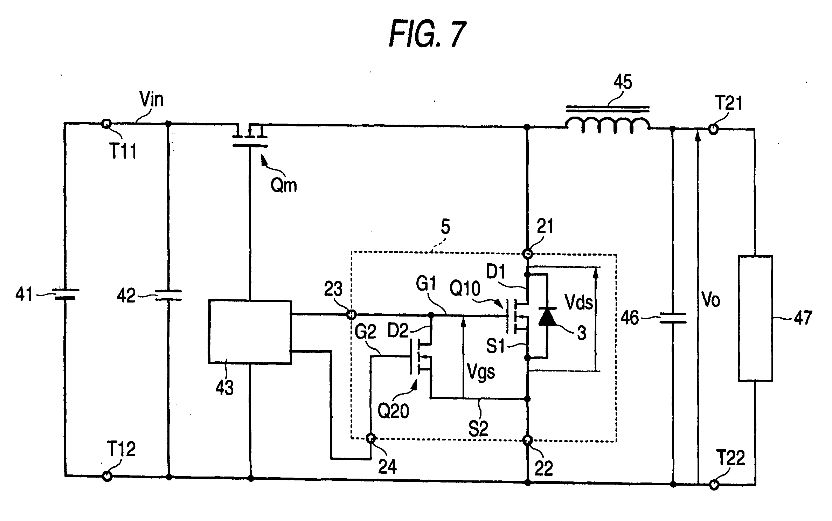

Fig. 7 shows a synchronous rectifier system step-down DC-to-DC converter using a semiconductor device shown in Figs. 1 through 4 as a commutation switch device 5.

In this embodiment, a DC voltage or a voltage Vin supplied from a DC power supply 41 to input terminals T11, T12 is switched using a control switch device Qm. A reference numeral 42 represents an input capacitor.

The control switch device Qm is controlled by a control circuit 43. The control circuit 43 controls an output voltage Vo by adjusting the on period (duty ratio) of the control switch device Qm in the control operation. The output voltage Vo is supplied to a load 47 via output terminals T21, T22 connected at both ends of a capacitor 42.

In the off period of the control switch device Qm, the commutation switch device 5 is turned on to continuously feed a current to an inductor 45. An idle period (dead time) is provided in which the control switch device Qm and the commutation switch device 5 are not turned on simultaneously in order to prevent occurrence of a through current. In this idle period, the current flowing across the inductor 45 flows in the diode 3 arranged in parallel with the commutation switch device 5. The on and off timings of the control switch device Qm and the commutation switch device 5 are controlled by the control circuit 43.

In case the control switch device Qm turns on with the idle period elapsed after the commutation switch device 5 has turned off, the drain-to-source voltage Vds of the first FET Q10 rises abruptly from 0 to the input voltage Vin.

The commutation switch device 5 is a semiconductor device according to the invention shown in Figs. 1 through 4 and has the drain D2 and the source S2 of the second FET Q20 connected to the gate G1 and the source S1 of the first FET Q10.

Thus, in synchronization with the timing the input voltage Vin is supplied to the first FET Q10 when the control switch device Qm turns on with the idle period elapsed after the first FET Q10 turning on, the drive signal SG2 is supplied to the external terminal 24 to turn on the second FET Q20. This causes the second FET Q20 to short-circuit the gate G1 and the source S1 of the first FET Q10, thereby short-circuiting the gate-to-source capacitance Cgs of the first FET Q10 with low impedance.

Further, the first FET Q10 and the second FET Q20 are in the same package 1 and the wiring impedance across the second FET Q20 and the first FET Q10 is remarkably low so that it is possible to decrease the gate-to-source voltage Vgs sufficiently below the threshold voltage. This reliably avoids the risk of the first FET Q10 that should be off entering the on state (self turn-on state).

Further, the package 1 comprises external terminals 21 through 24 on its outer surface. The drains D1, D2, sources S1, S2 and gates G1, G2 of the first and second FETs are connected to these terminals 21 through 24. Thus the package 1 can be directly mounted on a circuit board as a single component.

While not shown, a semiconductor device shown in Figs. 4 through 6 can be used as the commutation switch device 5. A semiconductor device according to the invention can be used as a synchronous rectifying device of an output rectifier circuit in an isolated-type DC-to-DC converter equipped with a transformer for power conversion.

As mentioned earlier, according to the invention, the following advantages are obtained:
(a) A semiconductor device that can short-circuit with a low impedance a gate-to-source capacitance of an FET as a main switch device and a DC-to-DC converter that uses the semiconductor device are provided.
(b) A semiconductor device and a DC-to-DC converter that can contribute to reduction of size, number of parts and costs are provided.

## Claims

1. A semiconductor device comprising:
a first field effect transistor that composes a main switch;
a second field effect transistor that has its drain and source connected to the gate and the source of said first field effect transistor; and
a package having external terminals on its outer surface, in that said first field effect transistor and said second field effect transistor are placed,
wherein said external terminals are connected with the drains, sources or gates of said first and second field effect transistors.

2. A semiconductor device according to claim 1, wherein said first and said second field effect transistors are formed in a single chip.

3. A semiconductor device according to claim 1, wherein said first and said second field effect transistors are formed in separate chips.

4. A semiconductor device according to claim 1, wherein said semiconductor device further comprises a third field effect transistor formed in said package, a source being connected to the gate of said first field effect transistor, agate is connected to said gate of said second field effect transistor, and a drain is connected to said external terminal.

5. A semiconductor device according to any one of claims 1 through 4, wherein said semiconductor device is used as one of a switch device and a rectifying device.

6. A DC-to-DC converter having a synchronous rectifier circuit wherein said synchronous rectifier circuit comprises a rectifying device includes a semiconductor device comprising:
a first field effect transistor that composes a main switch;
a second field effect transistor that has its drain and source connected to the gate and the source of said first field effect transistor; and
a package having external terminals on its outer surface, in that said first field effect transistor and said second field effect transistor are placed,
wherein said external terminals are connected with the drains, sources or gates of said first and second field effect transistors.

7. A DC-to-DC converter according to claim 6, wherein said first and said second field effect transistors are formed in a single chip.

8. A DC-to-DC converter according to claim 6, wherein said first and said second field effect transistors are formed in separate chips.

9. A DC-to-DC converter according to claim 6, wherein said semiconductor device further comprises a third field effect transistor formed in said package, a source being connected to the gate of said first field effect transistor, a gate is connected to said gate of said second field effect transistor, and a drain is connected to said external terminal.

10. A DC-to-DC converter according to any one of claims 6 through 9, wherein said semiconductor device is used as one of a switch device and a rectifying device.
